# EUROPÄISCHE PATENTSCHRIFT

(11) **EP 0 310 768 B1**
(45) Veröffentlichungstag und Bekanntmachung des Hinweises auf die Patenterteilung: **24.02.1993**
(21) Anmeldenummer: 88111953.1
(22) Anmeldetag: 25.07.1988
(51) Int. Cl.: G05G 5/02, G01P 13/04

(54) **Digitaler Impulsgeber**
Digital pulse generator
Générateur d'impulsion numérique

(30) Priorität: 22.09.1987 DE 3731784
(43) Veröffentlichungstag der Anmeldung: 12.04.1989
(73) Patentinhaber: Deutsche Thomson-Brandt GmbH, 78003 Villingen-Schwenningen (DE)
(72) Erfinder: Schmitz, Friedrich, D-7730 Villingen-Schwenningen (DE)

(56) Entgegenhaltungen:
- DE-A- 2 840 407
- DE-A- 2 931 175
- DE-A- 3 015 971
- DE-C- 3 419 972

## Beschreibung

Die vorliegende Erfindung betrifft einen digitalen Impulsgeber mit einer drehbaren Scheibe sowie mit dieser zusammenwirkenden Sensoren zur Abgabe von digitalen, drehrichtungsabhängigen Impulsen.

Derartige Impulsgeber sind in der Digitaltechnik als Digital-Encoder bekannt. Sie bestehen aus einer drehbaren Scheibe, die mechanisch durch Schleifkontakte, optisch durch opto-elektronische Sensoren oder magnetisch auf dem Hall-Effekt beruhend oder auch induktiv abtastbar sind. Die Scheibe wird dabei an dem impulsauslösenden Element wie Schleifer, Photodiode, Hallelement oder Spule vorbeibewegt. Es handelt sich dabei um zwei Sensoren, die um einen bestimmten Winkel versetzt angeordnet sind. Aus den von diesen gelieferten phasenverschobenen Impulsreihen kann auf die Drehrichtung des Impulsgebers geschlossen werden, so daß z.B. ein an diesen angeschlossener Zähler aufwärts oder abwärts zählt, von welchem das Zählergebnis digital oder nach einer Umwandlung analog ausgewertet werden kann.

Eine derartige Vorrichtung ist z.B. aus der DE-A-30 15 971 bekannt. Sie dient zum Erkennen der Links- bzw. Rechtsbewegung eines Körpers. Bei dieser Vorrichtung stehen zwei Sensoren (z.B. Hall-Generatoren) einer auf dem Umfang eines Drehkörpers angebrachten abwechselnden Folge von N-S-Magnetpolen in der Weise ortsfest gegenüber, daß ihr gegenseitiger Abstand ungleich dem Abstand der einzelnen Magnetpole ist. Dadurch kann mit Hilfe einer an die Sensoren angeschalteten Auswerteeinrichtung die Drehrichtung des Drehkörpers festgestellt werden, die sich aus der Phasenverschiebung der aus den Sensoren gelieferten Signale ergibt. Außerdem besitzt die bekannte Vorrichtung ein weiteres ortsfestes Magnetpolpaar, dessen Pole einen Abstand besitzen, der den Abständen der Magnetpole des Drehkörpers entspricht. Hierdurch soll erreicht werden, daß der Drehkörper immer in eine definierte Ruhestellung einrastet, wie es mechanisch z.B. durch die bekannte Kugelrastung gelöst wurde. Das Drehmomentverhalten der Vorrichtung ist hierbei aber unveränderbar.

Impulsgeber der vorgeschriebenen Art sind in der Digitalelektronik weit verbreitet und gewinnen auch in der Unterhaltungselektronik mehr an Bedeutung. Dabei wird der Impulsgeber mehrfach ausgenutzt, indem er nacheinander je nach Bedienungsbefehl des Gerätebenutzers unterschiedliche Funktionen steuert. So ist es z.B. möglich, durch diesen einzigen Impulsgeber die Sendereinstellung, die Laustärkeeinstellung, die Tiefen- und Höheneinstellung sowie die Tonbalance des Gerätes zu verändern. Das geschieht in der Weise, daß dem Impulsgeber durch Vorwahltasten diese verschiedenen Funktionen zugeordnet werden.

Der Erfindung liegt die Aufgabe zugrunde, einen Impulsgeber derart zu gestalten, daß dessen Bedienung erleichtert wird. Diese Aufgabe wird durch die im Patentanspruch 1 angegebene Erfindung gelöst. Weitere vorteilhafte Ausgestaltungen der Erfindung ergeben sich aus den Unteransprüchen.

Die Erfindung bringt den Vorteil, daß der Impulsgeber zur Verstellung der Lautstärke durch ein gerastetes Verhalten anders wirkt als z.B. bei der Verstellung der Senderwahl, bei welcher der Impulsgeber schwungradähnlichen Charakter besitzt. Bei der Verstellung von Tiefen, Höhen oder der Tonbalance des Audioverstärkers dagegen ist unter Umständen ein konstantes größeres Drehmoment wünschenswert.

Nachstand wird die Erfindung an einem Ausführungsbeispiel erläutert.
Figur 1 zeigt die Draufsicht und
Figur 2 zeigt die Seitenansicht der Anordnung.

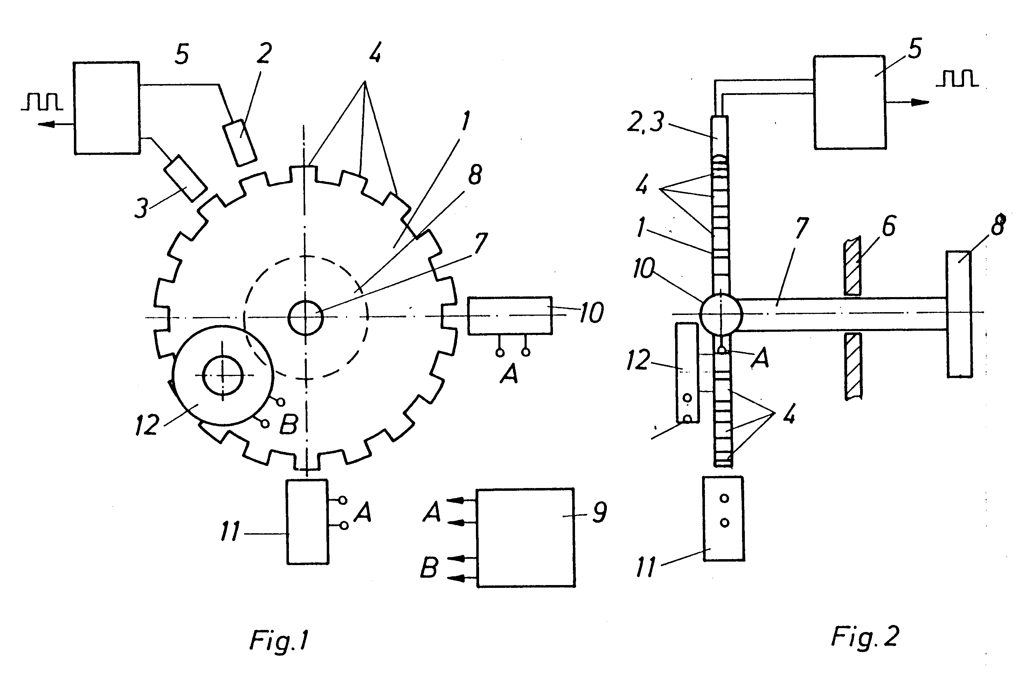

In den Figuren 1 und 2 ist ein üblicher Aufbau eines Impulsgebers schematisch dargestellt. Er besteht aus einer Scheibe 1, die an ihrem Umfang in gleichmäßigen Winkelabständen ebenso gleichmäßige Vorsprünge 4 besitzt. Diese wirken auf Sensoren 2 und 3 ein, die aus Spulen bestehen, welche mit den Vorsprüngen 4 der Scheibe 1, die als Magnete ausgebildet sind, zusammenwirken. Die Sensoren 2 und 3 können aber auch in Form von Gabellichtschranken ausgebildet sein, die die Vorsprünge 4 der Scheibe 1 umfassen. Aus den Signalen der Sensoren 2 und 3 wird in einer Auswerteschaltung 5 sowohl die Drehrichtung der Scheibe 1 als auch die Impulsanzahl zwecks schrittweiser Verstellung eines Wertes zur Verstellung von Funktionsgrößen detektiert.

Die Scheibe 1 wird über eine in einem Lager 6 gelagerte Achse 7 bewegt, die der Bedienende über eine Handhabe 8 antreibt.

Wird von der Bedienungsfunktion ein gerasteter Betrieb des Impulsgebers gefordert, wird über eine Steuereinheit 9 ein Strom durch Magnete 10 und 11 geschickt, welche in einem bestimmten Winkelabstand am Umfang der Scheibe 1 gegenüber den Vorsprüngen 4 angeordnet sind. Dadurch ergibt sich eine gefühlsmäßige in kleinen Winkelschritten erfolgende Drehung der Scheibe 1. Die Stärke der Rasterwirkung ist durch die Größe des Stromes durch die Magnete 10 und 11 einstellbar.

Wird bei einer anderen Bedienfunktion eine ungerastete aber mit Reibungsverhalten versehene Drehung der Scheibe 1 und somit des Impulsgebes verlangt, kann dies dadurch erreicht werden, daß von der Steuereinheit 9 eine Wirbelstrombremse 12 erregt wird, deren Wirksamkeit durch einen von der Steuereinheit 9 erzeugten Strom entsprechender Größe veränderbar ist. Dabei kann die Scheibe 1 in vorteilhafter Weise selbst als Teil der Wirbelstrombremse ausgebildet sein. Es ist auch denkbar, die mit Reibung versehene Drehung durch einen Motor im Kurzschlußbetrieb zu erzeugen.

Wird eine Drehung mit Schwungradeffekt verlangt, z.B. bei der Sendereinstellung eines Empfangsgerätes, wird der Strom durch die Magnete 10 und 11 und die Wirbelstrombremse 12 abgeschaltet, wobei eine in der Handhabe 8 angeordnete träge Masse diesen Effekt unterstützt.

## Patentansprüche

1. Digitaler Impulsgeber mit einer drehbaren Scheibe (1), sowie mit dieser zusammenwirkenden Sensoren (2, 3) zur Abgabe von digitalen von der Drehrichtung des Impulsgebers abhängigen Impulsen und mit einer Vorrichtung, (9, 10, 11, 12) die das Drehmomentverhalten des Impulsgebers ändert, **dadurch gekennzeichnet,** daß die Vorrichtung (9, 10, 11, 12) das Drehmomentverhalten in Abhängigkeit von der Funktion des Impulsgebers (1, 2, 3, 4, 5) verändert.

2. Digitaler Impulsgeber nach Anspruch 1, **dadurch gekennzeichnet,** daß die Vorrichtung (9, 10, 11, 12) den Impulsgeber (1, 2, 3, 4, 5) je nach Funktion in eine gerastete oder in eine schwer- oder leichtgängige Betriebsart umschaltet.

3. Digitaler Impulsgeber nach Anspruch 1, **dadurch gekennzeichnet,** daß der gerastete Betrieb mit Hilfe einer Anordnung aus Elektromagneten (10, 11) in Zusammenwirken mit der Scheibe (1) des Impulsgebers erzeugt wird.

4. Digitaler Impulsgeber nach Anspruch 1, **dadurch gekennzeichnet,** daß die Umschaltung auf die leicht- oder schwergängige Betriebsart mit Hilfe einer Wirbelstrombremse (12) erfolgt.

5. Digitaler Impulsgeber nach Anspruch 3, **dadurch gekennzeichnet,** daß die Scheibe (1) des Impulsgebers (1, 2, 3, 4, 5) als Teil der Wirbelstrombremse (12) ausgebildet ist.

## Claims

1. A digital pulse generator with a rotatable disc (1) and with sensors (2,3) cooperating therewith, for emitting digital pulses which depend on the direction of rotation of the pulse generator and with a device (9,10,11,12) which changes the torque characteristics of the pulse generator, **characterised in that** the device (9,10,11,12) changes the torque characteristics in dependence on the function of the pulse generator (1,2,3,4,5).

2. A digital pulse generator according to claim 1, **characterised in that** the device (9,10,11,12) switches over the pulse generator (1,2,3,4,5) according to the function into a latched or into a stiff or easy-running mode.

3. A digital pulse generator according to claim 1, **characterised in that** the latched operation is produced with the aid of an arrangement consisting of electromagnets (10,11) in cooperation with the disc (1) of the pulse generator.

4. A digital pulse generator according to claim 1, **characterised in that** switchover to the easy-running or stiff mode takes place with the aid of an eddy-current brake (12).

5. A digital pulse generator according to claim 3, **characterised in that** the disc (1) of the pulse generator (1,2,3,4,5) is formed as part of the eddy-current brake (12).

## Revendications

1. Générateur d'impulsion numérique avec un disque rotatif (1) ainsi qu'avec des capteurs (2, 3) qui agissent avec celui-ci pour donner des impulsions numériques qui dépendent du sens de rotation du générateur d'impulsions et avec un dispositif (9, 10, 11, 12) qui fait varier le comportement du couple de rotation du générateur d'impulsions, **caractérisé en ce** que le dispositif (9, 10, 11, 12) fait varier le comportement du couple de rotation en fonction de la fonction du générateur d'impulsions (1, 2, 3, 4, 5).

2. Générateur d'impulsion numérique selon la revendication 1, **caractérisé en ce** que le dispositif (9, 10, 11, 12) commute le générateur d'impulsions (1, 2, 3, 4, 5) selon la fonction sur un fonctionnement à encoche ou sur un type de fonctionnement dur ou facile.

3. Générateur d'impulsion numérique selon la revendication 1, **caractérisé en ce** que le fonctionnement à encoche est produit à l'aide d'un dispositif composé d'électroaimants (10, 11) qui agissent avec le disque (1) du générateur d'impulsions.

4. Générateur d'impulsion numérique selon la revendication 1, **caractérisé en ce** que la commutation sur le fonctionnement facile ou dur se fait à l'aide d'un frein à courant parasites (12).

5. Générateur d'impulsion numérique selon la revendication 3, **caractérisé en ce** que le disque (1) du générateur d'impulsion (1, 2, 3, 4, 5) est configuré comme une partie du frein à courants parasites (12).
